# EUROPEAN PATENT SPECIFICATION

(11) **EP 2 255 399 B1**
(45) Date of publication and mention of the grant of the patent: **22.08.2018**
(21) Application number: 09711180.1
(22) Date of filing: 13.02.2009
(51) Int. Cl.: H01L 51/56, H01L 51/52

(54) **METHOD OF MANUFACTURING AN ENCAPSULATED ELECTRONIC DEVICE**
HERSTELLUNGSVERFAHREN FÜR EINE EINGEKAPSELTE ELEKTRONISCHE ANORDNUNG
PROCÉDÉ DE FABRICATION D'UN DISPOSITIF ÉLECTRONIQUE ENCAPSULÉ

(30) Priority: 15.02.2008 EP 08151524
(43) Date of publication of application: 01.12.2010
(73) Proprietor: Nederlandse Organisatie voor toegepast- natuurwetenschappelijk onderzoek TNO, 2595 DA 's-Gravenhage (NL); Koninklijke Philips N.V., 5656 AE Eindhoven (NL)
(72) Inventor: TOONEN, Leonardus Maria, 5502 RL Veldhoven (NL); RENSING, Petrus Alexander, 5624 ER Eindhoven (NL); VAN MOL, Antonius Maria Bernardus, 5658 HC Eindhoven (NL); LIFKA, Herbert, 5691 LP Son En Breugel (NL); TANASE, Cristina, 5581 CG Waalre (NL)
(74) Representative: V.O.
(86) International application number: PCT/NL2009/050061
(87) International publication number: WO 2009/102201

(56) References cited:
- EP-A- 1 589 584
- WO-A-2008/139370
- WO-A1-2008/018737
- US-A- 5 757 126
- US-A1- 2003 127 973
- US-A1- 2005 023 974
- US-A1- 2005 202 646
- US-A1- 2005 282 307

## Description

### BACKGROUND OF THE INVENTION

### Field of the invention

The present invention relates to a method of manufacturing an encapsulated electronic device.

### Related Art

A new generation of thin film based devices, such as organic light emitting diodes (OLED) for lighting and displays, thin film batteries, thin film organic solar cells, electrochromic foils, electrophoretic displays, etc., have the potential to become a next revolution in electronic systems. These thin film devices have to be protected from contamination by moisture. For that purpose, the last decade several thin film barrier coatings have been developed, often based on a stack of organic and inorganic layers.

An example thereof is described in US 2001/0015620. The moisture protected thin film based devices described therein comprises a foundation having a top of a first polymer layer, a first ceramic layer on the first polymer layer, and a second polymer layer on the first ceramic layer. An organic light emitting device is constructed on the second polymer layer of the top of the foundation. A cover is deposited on the organic light emitting device. The cover comprises subsequently a third polymer layer with a second ceramic layer thereon and a fourth polymer layer on said second ceramic layer. The foundation, and the cover encapsulate the organic light emitting device as a flexible environmental barrier.

Although the construction described in the cited US2001/0015620 clearly improves the lifetime of the OLED, it has been observed by the inventors that the known device still suffers from a gradual degradation by moisture.

It is noted that US2005/023974 describes an organic light emitting device structure, which comprises: (a) a substrate; (b) a first electrode disposed over the substrate; (c) a polymeric layer comprising a conductive polymer disposed over the first electrode; (d) an organic layer consisting essentially of small molecule material disposed over and in direct contact with said polymeric layer; (e) a second electrode disposed over the organic layer; and (f) a thin film encapsulation region disposed over the second electrode. An organic light emitting device is also provided, which comprises: (a) a polymer layer comprising a hole injecting conductive polymer and (b) a small molecule layer comprising an emissive small molecule material. In certain embodiments, the small molecule layer further comprises a small molecule hole injection layer. In an embodiment, the encapsulating region is a composite region comprising a series of cooperative barrier layers. The series of cooperative barrier layers include both layers of planarizing material and layers of high-density material. These cooperative barrier layers are preferably provided in an alternating configuration. For example, 1 to 10 pairs of these layers may be used. Preferred high-density materials include inorganic materials.

It is further noted that US2005/202646 A1 discloses an edge-sealed, encapsulated environmentally sensitive device. The device includes at least one initial barrier stack, an environmentally sensitive device, and at least one additional barrier stack. The barrier stacks include at least one decoupling layer and at least one barrier layer. The environmentally sensitive device is sealed between the at least one initial barrier stack and the at least one additional barrier stack. A method of making the edge-sealed, encapsulated environmentally sensitive device is also disclosed. The device is manufactured on a substrate that can be removed after the device is made, if desired. The substrate is for example glass, e.g. a thin, flexible, glass sheet.

### SUMMARY OF THE INVENTION

It is a purpose of the invention to provide a method to manufacture an improved encapsulated electronic device.

According to an aspect of the present invention a method for manufacturing an encapsulated electronic device is provided comprising the steps of
- providing a substrate of an inorganic material,
- providing an encapsulated electronic device on the substrate subsequently comprising the following sub steps,
- providing a first barrier structure with at least one inorganic layer and at least one organic layer,
- providing an electronic device between the first and a second barrier structure,
- providing the second barrier structure, with at least one inorganic layer and at least one organic layer,
wherein the at least one inorganic layer of the second barrier structure contacts the at least one inorganic layer of the first barrier structure.

In this way an electronic encapsulated device is obtained. The encapsulated electronic device is released from the substrate after its completion.

The method of the present invention further complies with one of the following options denoted as A,B and as further specified below

According to option A, the encapsulated device comprises a patterned additional organic layer being a release layer that is applied at said first barrier structure at a side remote from the electronic device, and the pattern forming an array of microlenses in said release layer was obtained by using a substrate with a complementary pattern as the substrate.

According to option B, at least one further inorganic layer of the first barrier structure of the encapsulated device is provided with a pattern forming an array of microlenses by forming a release layer with a patterned surface pointing away from the substrate and forming the further inorganic layer on the release layer such that it follows the release layer .

The substrate facilitates the handling of the thin film based device under construction as it provides stiffness thereto. By removing the substrate at the end, the end-product is more flexible. It has, however, been observed that removal of the substrate tended to lead to premature failure of the product and therewith resulted in a decrease of the yield of the manufacturing process. It was found by the inventors that the claimed method results in an increased yield, as compared to a method wherein a substrate of an organic material is removed from the encapsulated electronic product. It is suspected that this improvement of yield is achieved as the inorganic material attracts dust-particles from the atmosphere less than is the case with organic materials. Dust particles on the substrate tend to cause pinholes in the inorganic layer, resulting in leakage of moisture into the electronic device.

The at least one inorganic layer of the first barrier structure and the at least one inorganic layer of the second barrier structure contact each outside an area occupied by the electronic device. In this way a lateral penetration of moisture toward the electronic device is counteracted. Although already a further reduction in the penetration of moisture is obtained if the said inorganic layer contact each other over a part of a circumference around the electronic device, preferably the said inorganic layers substantially contact each other at a full circumference around the electronic device. Therewith the at least one inorganic layer of the first barrier structure and the at least one inorganic layer of the second barrier structure cooperate to encapsulate the electronic device laterally. Nevertheless the contact between the said inorganic layers may be interrupted by electrical conductors coupled to the electronic device.

Contrary thereto, in the known device the inorganic layers are separated by organic layers. Accordingly the inorganic layers cannot prevent that moisture in the environment of the device penetrates laterally towards the device.

In an embodiment the first barrier structure comprises a first inorganic layer, a first organic layer forming the at least one organic layer and a second inorganic layer forming the at least one inorganic layer, the first organic layer being arranged between the first and the second inorganic layer. Incidentally, it may occur that an organic layer has micro-holes, which could form a path for moisture. In this embodiment, even if the first and the second inorganic layer have micro-holes the probability is small that the micro-holes in these layers are positioned opposite to each other. Accordingly, the probability of a leak of moisture is substantially reduced.

For analogous reasons it is favorable if the second barrier structure comprises a third inorganic layer forming the at least one inorganic layer, a second organic layer forming the at least one organic layer and a fourth inorganic layer, the second organic layer being arranged between the third and the fourth inorganic layer.

An even better moisture protection is obtained if at least one organic layer comprises a moisture getter.

An embodiment is characterized in that the first barrier structure and the second barrier structure have a substantially equal thickness and configuration. In this embodiment the amount of deformation of the electronic device between the barrier structures is as small as possible in case the encapsulated electronic device is bended.

An embodiment is characterized in that the electronic device is an OLED device, and in that a patterned additional organic layer is applied at at least one of the barrier structures at a side remote from the electronic device. Such a patterned additional organic layer improves an output efficiency of visible or non-visible radiation generated by the OLED. Additionally the pattern may be used to control a direction in which radiation emanates from the encapsulated electronic device. Alternatively, or in addition, in an embodiment at least one organic layer comprises optically active particles. Also in this way the outcoupling of light may be improved. For example in an embodiment the optically active particles are microlenses. In another embodiment the optically active particles are scattering particles.

The claimed method of manufacturing an encapsulated electronic device is characterized in that the substrate or a release layer thereon is patterned before the step of providing an encapsulated electronic device. The patterned (corrugated) substrate or the release layer then functions as a template for the first inorganic layer that is applied on the substrate. Corrugation of the device-air interface leads to an improvement of 20 to 40% of the light extraction from the device by reduction of trapping of the light by total internal reflection. By applying the corrugation of the first inorganic layer in this way an improved output efficiency of the encapsulated electronic device is realized without additional manufacturing steps. Furthermore it reduces the number of (reflecting) interfaces between active layer and the outer surface in comparison with a situation where a separate corrugation layer is attached to the surface of the device.

Various shapes and sizes of the corrugations are suitable to improve light output e.g., corrugations in the shape of gratings or microlenses both improve the light output from a device to roughly the same extent. It has been established that the corrugation depth is an important factor, a depth of approx. 0.5 micrometer being a typically effective depth for a white emitting device.

Corrugation of the "stamp' to produce the removable substrate can be achieved by many conventional techniques, e.g., by using etching techniques to obtain well-defined surfaces or by (sand)blasting for less well-defined surfaces. In order to facilitate good detachment of the device from the substrate, a release-supporting layer can be used that can be later washed away from the surface of the device, if necessary. The release-supporting layer, briefly denoted as release layer, should be relatively thin in comparison to the dimension of the corrugation pattern, so that the corrugation pattern is not significantly disturbed. Preferably the thickness of the release layer is less than 5 times the dimension of the corrugation pattern. The release layer may be washed from the device after the device is removed from the substrate. The inorganic layers may be applied by all kinds of physical vapour deposition methods such as thermal evaporation, e-beam evaporation, sputtering, magnetron sputtering, reactive sputtering, reactive evaporation, etc. and all kinds of chemical vapour deposition methods such as thermal chemical vapour deposition (CVD), photo assisted chemical vapour deposition (PACVD), plasma enhanced chemical vapour deposition (PECVD), etc.

The organic layers may be applied by all kinds of coatings techniques, such spin coating, slot-die coating, kiss-coating, hot-melt coating, spray coating, etc. and all kinds of printing techniques, such as inkjet printing, gravure printing, flexographic printing, screen printing, rotary screen printing, etc.

### BRIEF DESCRIPTION OF THE DRAWINGS

These and other aspects are described in more detail with reference to the drawing. Therein:
Figure 1 shows a first example of an encapsulated electronic device useful for understanding the invention,
Figure 1A shows a plurality of encapsulated electronic devices at a substrate,
Figure 2A - 2K show respective steps in a method for manufacturing an encapsulated electronic device useful for understanding the invention,
Figure 3 shows a first embodiment of an encapsulated electronic device obtained with the method according to the invention,
Figure 4 shows a second embodiment of an encapsulated electronic device obtained with the method according to the invention,
Figure 5A, 5B show an example of an encapsulated electronic device not covered by the invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention as defined in the claims. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.. In case of conflict, the present specification, including definitions, will control. In addition, the materials, methods, and examples are illustrative only and not intended to be limiting.

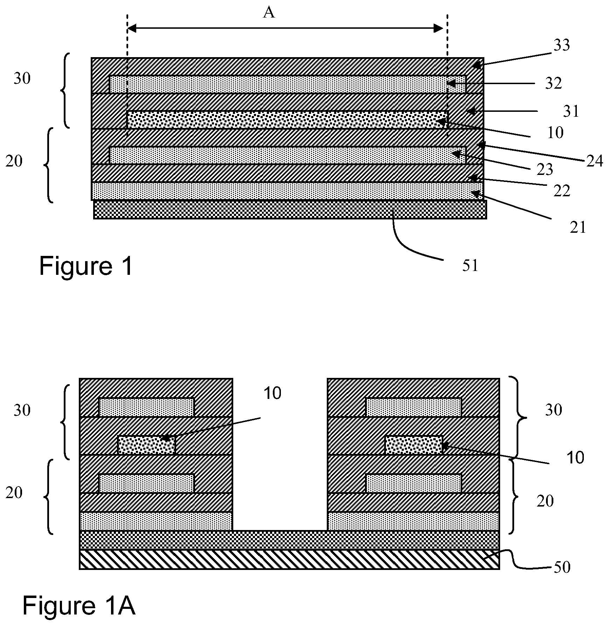

Figure 1 shows an example of an encapsulated electronic device. The encapsulated electronic device comprises an electronic device 10 that is encapsulated between a first barrier structure 20 and a second barrier structure 30.

More in particular the first barrier structure 20 comprises at least one inorganic 24 at least one organic layer 23. Likewise, the second barrier structure 30 comprises at least one inorganic layer 31 and at least one organic layer 32. The at least one inorganic layer 24 of the first barrier structure 20 and the at least one inorganic layer 31 of the second barrier structure 30 contact each other outside an area A occupied by the electronic device 10. The organic layer may comprise a moisture getter. Suitable organic materials for this purpose may include, but are not limited to
- (poly)alkoxy silanes (examples of which include, but are not limited to: 3-trimethoxysilylpropylmethacrylate),
- (poly)isocyanates (examples of which include, but are not limited to: poly [(phenyl isocyanate) -co-formaldehyde]),
- (poly)oxazolidines (examples of which include, but are not limited to: 3-ethyl-2-methyl-2-(3-methylbutyl)-1,3-oxazolidine(Zoldine® MS-PLUS)),
- (poly)anhydrides,
- (poly)cyanoacrylates,
- linear polysugars (examples of which include, but are not limited to: polysaccharides, cellulose, hydroxyethylcellulose),
- cyclic polysugars (examples of which include, but are not limited to: cyclodextrins)
   Suitable inorganic moisture getters may include, but are not limited to
- rare earth metals (examples of which include, but are not limited to: Li, Na, K),
- rare earth metal oxides (examples of which include, but are not limited to: Li2O, Na2O, K2O),
- alkaline earth metals (examples of which include, but are not limited to: Ca, Ba, Mg),
- alkaline earth metal oxides (examples of which include, but are not limited to: CaO, BaO, MgO),
- transition metals (examples of which include, but are not limited to: Hf, Ti, Al, Cr, V, Zr),
- transition metal oxides (examples of which include, but are not limited to: PbO, Bi2O3, SrO, ZnO, CuO),
- boron oxide,
- high valency metal chlorides such as SiCl4, WCl6, ZrCl4, TiCl4, CoCl2,
- P2O5,
- amorphous hydrogenated silicon carbide,
- salts of cesium (examples of which include, but are not limited to: CsF),
- lanthanide salts (examples of which include, but are not limited to: LaF3),
- silicate,
- alumina,
- organometallic complexes of metals with a coordination number of 6,
- zeolites (examples of which include, but are not limited to molecular sieves),
- clay dessicants.

Inorganic getter materials are preferably provided as particles in an organic layer. In particular CaO or MgO particles are suitable for this purpose.

In the embodiment shown the first barrier structure 20 comprises a first inorganic layer 22, a first organic layer 23 forming the at least one organic layer and a second inorganic layer 24 forming the at least one inorganic layer. The first organic layer 23 is arranged between the first and the second inorganic layer 22, 24.

Likewise, the second barrier structure 30 comprises a third inorganic layer 31 forming the at least one inorganic layer, a second organic layer 32 forming the at least one organic layer and a fourth inorganic layer 33. The second organic layer 32 is arranged between the third and the fourth inorganic layer 31, 33.

In the embodiment shown an additional organic layer 21 is applied at at least one of the barrier structures 20 at a side remote from the electronic device 10. Furthermore a release layer 51 is provided with which the stack 10, 20, 30 was released from a substrate.

The electronic device is for example an organic light emitting diode (OLED) for lighting and displays, a thin film battery, a thin film organic solar cell, an electrochromic foil or an electrophoretic displays.

The inorganic layers have a water vapour transmission rate of at most 10⁻⁴ g.m⁻².day⁻¹.

The organic layers may be provided from a cross-linked (thermoset) material, an elastomer, a linear polymer, or a branched or hyper-branched polymer system or any combination of the aforementioned, optionally filled with inorganic particles of a size small enough to still guarantee light transmission. The material is processed either from solution or as a 100% solids material. Curing or drying may exemplary occur by irradiation of the wet material, pure, or suitably formulated with a photo- or heat-sensitive radical or super-acid initiator, with UV-light, visible light, infrared light or heat, E-beam, g-rays or any combination of the aforementioned. The material of the organic layer preferably has a low specific water vapour transmission rate and a high hydrophobicity. Examples of suitable cross-linking (thermoset) systems are any single one or any combination of aliphatic or aromatic epoxy acrylates, urethane acrylates, polyester acrylates, polyether acrylates, saturated hydrocarbon acrylates, epoxides, epoxide-amine systems, epoxide-carboxylic acid combinations, oxetanes, vinyl ethers, vinyl derivatives, and thiol-ene systems. Suitable examples of elastomeric materials are polysiloxanes. Examples of suitable branched or linear polymeric systems are any single one or any copolymer or physical combination of polyacrylates, polyesters, polyethers, polypropylenes, polyethylenes, polybutadienes, polynorbornene, cyclic olefin copolymers, polyvinylidenefluoride, polyvinylidenechloride, polyvinylchloride, polytetrafluoroethylene, polychlorotrifluoroethylene, polyhexafluoropropylene. The organic layers may have a thickness between 0.1 - 100 µm, preferably between 5 and 50 µm.

The inorganic layer(s) may be any ceramic including but not limited to metal oxide, such as indium oxide (In2O3), tin oxide (SnO2), indium tin oxide (ITO), a metal nitride, such as aluminium nitride (AIN), silicon nitride (SiN), a carbide, such as silicon carbide, a metal oxynitride, e.g. siliconoxynitride, or any other combination such as metal oxy carbides, metal carbonitrides, metal oxycarbonitrides. In case that the electronic device has an optical function it is relevant that at least one side (foundation or cover) is substantially transparent ceramic. Suitable materials therefore are for example silicon oxide (SiO2), aluminum oxide (Al2O3), titanium oxide (TiO2), indium oxide (In2O3), tin oxide (SnO2), indium tin oxide (ITO, In203+SnO2), (SiC), silicon oxynitride (SiON) and combinations thereof.

The inorganic layer(s) are in practice substantially thinner than the organic layers. The inorganic layers should have a thickness in the range of 10 to 1000 nm, preferably in the range of 100 to 300 nm.

The total thickness of the first and the second barrier layer is preferably at least 50 µm. At a thickness substantially smaller than 50 µm, e.g. 20 µm, the resulting encapsulated electronic device tends to damage to quickly. Preferably the total thickness is less than 500 µm. If the thickness is substantially more, e.g. 1 mm, the flexibility of the product is impaired.

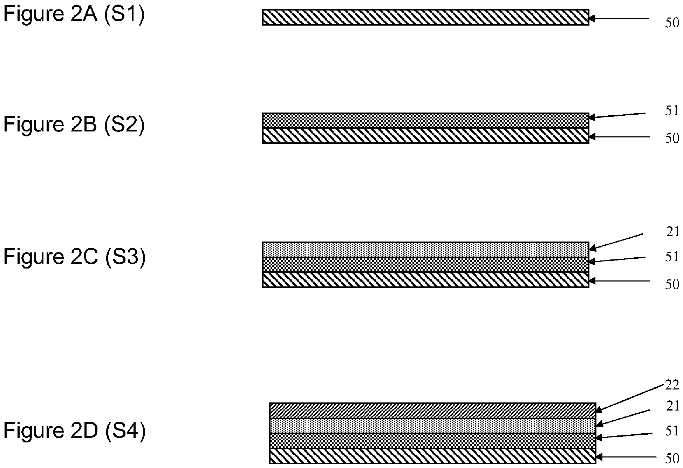

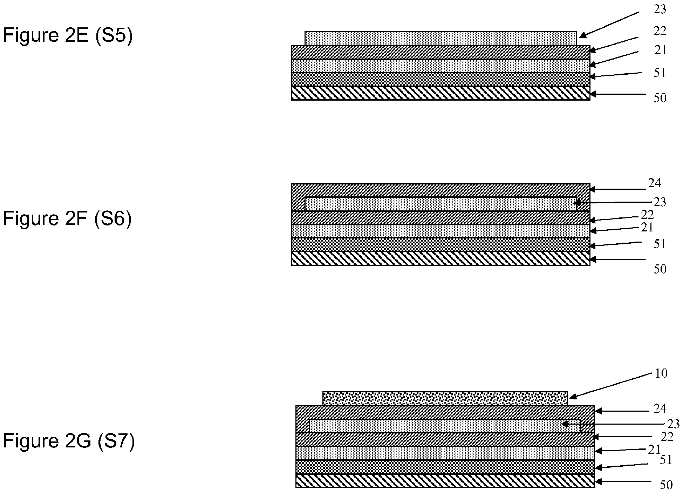

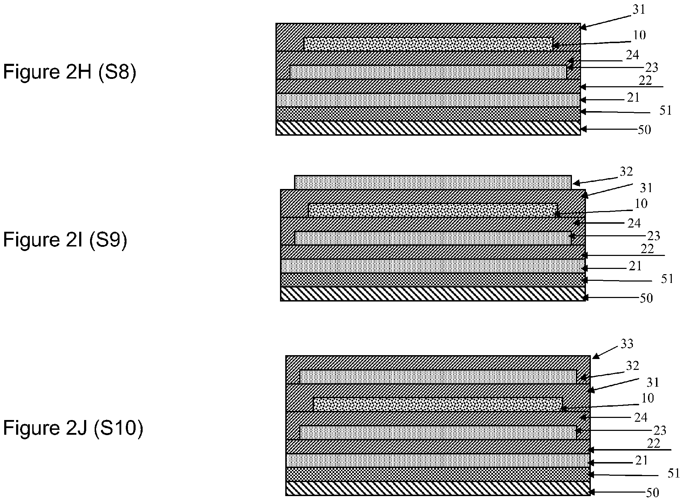

In the sequel a method of manufacturing an encapsulated device is described, with reference to Figures 2A - 2K. The figures 2A-2K respectively show steps S1-S11 of this method.

In step S1, illustrated in Figure 2A a substrate 50 is provided. The substrate is made of an inorganic material. The inorganic material may comprise e.g. a ceramic material, a glass or a metal.

In step 2B a release layer 51 is applied on the substrate. The methods described above for applying an organic layer are suitable for this purpose.

The release layer may comprise a silica organic based polymer such as polydimethylsiloxaan (PDMS), but may alternatively comprise another component that provides for a sufficient adhesion of the workpiece to the substrate 50 during manufacturing, but that allows an easy release of the workpiece once finished. Surprisingly, also materials used in the active layers of OLED devices, like PEDOT and LEP turned out to be suitable for this purpose. At release of the finished product from the substrate 50, the release layer 51 may stay with the product, or may stay with the substrate 50. If the release layer stays with the substrate it may be reused or removed.

In steps S3 to S5 a first barrier structure 20 is applied at the release layer. In the embodiment show these steps comprise:
Step S4, wherein a first inorganic layer 22 is applied,
Step S5, wherein a first organic layer 23 is applied at the first inorganic layer 22, and
Step S6, wherein a second inorganic layer 24 is applied at the first organic layer 23.

In this case step S4 is preceded by an additional step S3, wherein an additional organic layer 21 is applied at the release layer 51, so that the first inorganic layer 22 is applied at the first organic layer 21.

In step S7 an organic thin film electronic device is constructed. The construction of these devices, e.g. OLEDs, OFETs, organic solar cells etc is well known as such to the skilled person, and is therefore not described in detail here.

In steps S8 to S9 a second barrier structure 30 is applied on top of the organic thin film electronic device.

These steps comprise
Step S8, wherein a third inorganic layer 31 is applied,
Step S9, wherein a second organic layer 32 is applied at the third inorganic layer 31, and
Step S10, wherein a fourth inorganic layer 33 is applied at the first organic layer 32.

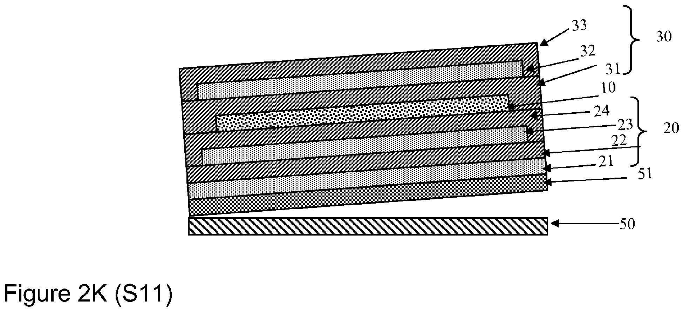

In a subsequent step S11, shown in Figure 2K, the product formed in the previous steps is released from the substrate 50. Therewith an encapsulated electronic device as shown in Figure 1 is obtained. As shown in Figure 1A more devices may be constructed on a single substrate 50.

For clarity it is not illustrated in the Figures how the electronic device 10 is electrically connected to external conductors. Preferably the electrical conductors to the electronic device are provided as an aluminium conductor with a molybdenum coating between subsequent inorganic layers 24, 21 for example. The molybdenum coating therein service as an adhesion layer. This step of applying the electrical conductors can be applied between step S7 and S8 according to the method described above. In an alternative embodiment an electrical connection to outside conductors is provided later, e.g. after step 2K. This is possible by punching respective holes through at least one of the barrier layers towards electrical connectors of the electronic device and filling these holes with a conductive material.

As a typical example, a UV-curable release polymer layer was formed on a glass substrate. After curing, a barrier structure was applied, subsequently comprising silicon nitride / organic / silicon nitride layers. On top of the barrier structure an OLED was deposited comprising an ITO anode, a PEDOT layer, a light-emitting polymer layer, and a Ca-Al cathode. The OLED was encapsulated by a further silicon nitride / organic / silicon nitride barrier structure and finally a further UV-curable layer equal in thickness to the first release layer was applied and cured. In this way the device obtained is fully symmetric. Additionally the further UV curable layer serves as an anti-scratch layer.

The whole stack comprising the encapsulated OLED was then peeled off the glass substrate, resulting in an essentially stressless, highly flexible device. By way of example, SiN inorganic layers having a thickness in a range between 150 en 300nm were applied by a silane-ammonia process in a PEVCD reactor. Organic layers of an acrylate having a thickness in the range of 20 to 50 µm were applied by spincoating Furthermore the ITO anode had a thickness in the range of 130 nm, and a sheet resistance of 20ohmsquare. The PEDOT layer had a thickness of 100nm and was dried at 110°C. The LEP layer had a thickness of 80 nm and the cathode comprised a layer of Ba with a thickness of 5nm Ba and a layer of Al having a thickness of 100nm Al (the latter was evaporated)

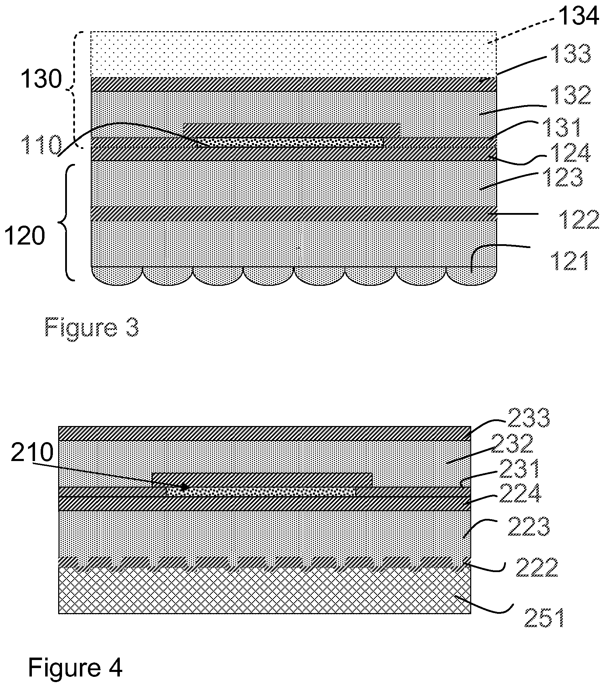

Figure 3 shows a preferred embodiment of the encapsulated electronic device obtained with a method according to the invention. Therein parts corresponding to those in Figure 1 have a reference number that is 100 higher. The encapsulated electronic device, i.e. an OLED shown therein comprises a patterned additional organic layer 121 that is applied at at least one of the barrier structures at a side remote from the electronic device. The pattern in the additional organic layer forms an array of microlenses that improve light outcoupling of the OLED. In this embodiment additional organic layer 121 is a release layer, and the pattern therein was obtained by using a substrate 50 with a complimentary pattern during the manufacturing steps illustrated in Figure 2A-2K. As shown in dashed mode in Figure 3, the second barrier structure 130 may include an additional organic layer 134. In this way it is achieved that the first and the second barrier structure 120, 130 have a substantially equal thickness.

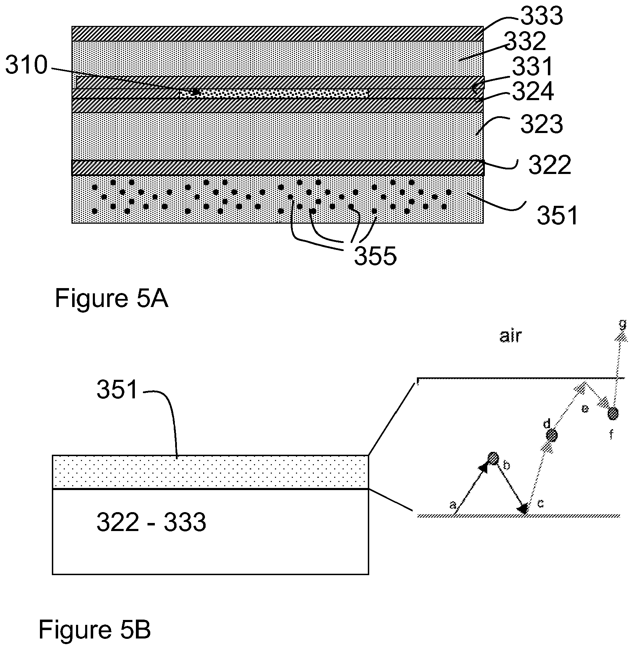

Figure 4 shows a second preferred embodiment. Parts therein corresponding to those in Figure 1 have a reference number that is 200 higher. In Figure 4 the release layer 251 is provided with a patterned surface pointing away from the substrate 50, between step S2 and S3 as illustrated in Figures 2B and 2C respectively. The first inorganic layer 222 follows this pattern. In this way a pattern of microlenses may be obtained between two organic layers 251, 223. An example not falling under the claimed invention is shown in Figures 5A and 5B. In these Figures parts corresponding to those in Figure 1 have a reference number that is 300 higher. In this embodiment the additional organic layer 351 comprises optically active particles 355, here, scattering particles. The scattering particles 351 have a relatively high refractive index (higher than 2 for example) with respect to the organic matrix that has low refractive index (1.5-1.6). The scattering particles are for example of titania (TiO₂) or zirconia (ZrO₂) particles.

The function of the particles 355 is illustrated in Figure 5B. Light emerges from the active layers of the OLED with an angular distribution at position "a". The ray impinges upon a particulate scatterer at "b", and is back scattered to point "c", which is the surface of the active layers of the OLED, for example an indium tin oxide layer (ITO). The ray is reflected at point "c", but also attenuated due to the finite reflectivity of the OLED. The ray then travels to point "d", is scattered again, and reaches the top air-glass interface a point "e" with an angle of incidence that exceeds the critical angle and undergoes total internal reflection. The ray is reflected back to a scattering particle ("f'), is back-scattered toward the air substrate interface (point "g"). This time the angle of incidence is less than the critical angle and the ray is transmitted across the interface.

Alternatively, the optically active particles 355 in the additional layer 351 may be microlenses. By selecting a distribution and shape of the optically active particles, the distribution of light emanating from the OLED may be controlled. The material to be selected for the micro lenses depends on the position where they are placed in the device. For example on the most outer substrate area they should have a refractive index lower than that of the layer that borders to the layer of micro lenses and close to the refractive index of air. If they are placed in a polymer matrix, e.g. in layer 323, or layer 332, they might have higher refractive index. In the case of shaped lenses, they can be either embedded into the organic matrix/or shaped by soft lithography,etc/but they can also be on top and the next inorganic layer will follow them. In this case they might have the same or different refractive index as the organic layer.

The microlenses primarily widen the escape cone for total internally reflected light incident at the air-substrate boundary. The microlenses simply redirect the light without introducing microcavities or other undesirable parasitic optical effects. The extraction of light at angles higher than the critical angle of substrate is enhanced. The height of the microlenses may range from 1um up to 100 um and the planar size is comparable or larger than the maximum wavelength of visible light emitted from the OLEDs and smaller than the OLED area (for example ranging from 1 µm up to 50 µm). The microlens density can vary from 5000 to about 1 000 000 lenses per square millimeter and will depend on their size. The shape of the microlenses is processed in such way that they do not introduce angular dependence or anisotropy. The microlenses may have a hemispheric shape, but may alternatively have the shape of a polyhedron, such as a trunked pyramid.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfil the functions of several items recited in the claims. The mere fact that certain measures are recited in mutually different claims does not indicate that a combination of these measures cannot be used to advantage. Any reference signs in the claims should not be construed as limiting the scope.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. Method of manufacturing an encapsulated electronic device comprising the steps of
- providing (S1) a substrate (50) of an inorganic material,
- providing an encapsulated electronic device on the substrate subsequently comprising the following sub steps,
- providing (S4-S6) a first barrier structure (20, 120) with at least one inorganic layer (24, 124, 224) and at least one organic layer (23, 123, 223),
- providing (S7) an electronic device (10, 110, 210) between the first and a second barrier structure (30, 130),
- providing (S8-S10) the second barrier structure (30, 130), with at least one inorganic layer (31, 131, 231) and at least one organic layer (32, 132, 232), wherein the at least one inorganic layer (31, 131, 231) of the second barrier structure (30, 130) contacts the at least one inorganic layer (24) of the first barrier structure, wherein the encapsulated electronic device is released (S11) from the substrate (50) after its completion, **characterized in that** the encapsulated device comprises a patterned additional organic layer (121) being a release layer that is applied at said first barrier structure at a side remote from the electronic device, and the pattern forming an array of microlenses in said release layer (121) was obtained by using a substrate with a complementary pattern as the substrate (50) or wherein at least one further inorganic layer (222) of the first barrier structure of the encapsulated device is provided with a pattern forming an array of microlenses by forming a release layer (251) with a patterned surface pointing away from the substrate and forming the further inorganic layer (222) on the release layer (251) such that it follows the release layer (251).

2. Method according to claim 1, **characterized in that** the first barrier structure (20) comprises a first inorganic layer (22), a first organic layer (23) forming the at least one organic layer and a second inorganic layer (24) forming the at least one inorganic layer, the first organic layer being arranged between the first and the second inorganic layer.

3. Method according to claim 1 or 2, **characterized in that** the second barrier structure (30) comprises a third inorganic layer (31) forming the at least one inorganic layer, a second organic layer (32) forming the at least one organic layer and a fourth inorganic layer (33), the second organic layer being arranged between the third and the fourth inorganic layer.

4. Method according to one of the previous claims, **characterized in that** the first barrier structure (20) and the second barrier structure (30) have an equal thickness.

5. Method according to claim 1, wherein said encapsulated electronic device is an OLED device having said patterned additional organic layer (121) being a release layer that is applied at said first barrier structure at a side remote from the electronic device and **characterized in that** at least one organic layer (351) comprises microlenses or scattering particles (355).

6. Method according to one of the previous claims **characterized in that** at least one organic layer comprises a moisture getter.

## Patentansprüche

1. Verfahren zur Herstellung einer eingekapselten elektronischen Anordnung, umfassend folgende Schritte:
- Bereitstellung (S1) eines Substrats (50) aus anorganischem Material,
- Bereitstellung einer elektronischen Anordnung auf dem Substrat, anschließend umfassend folgende Teilschritte,
- Bereitstellung (S4-S6) einer ersten Barrierestruktur (20, 120) mit mindestens einer anorganischen Schicht (24, 124, 224) und mindestens einer organischen Schicht (23, 123, 223),
- Bereitstellung (S7) einer elektronischen Anordnung (10, 110, 210) zwischen der ersten und einer zweiten Barrierestruktur (30, 130),
- Bereitstellung (S8-S10) der zweiten Barrierestruktur (30, 130) mit mindestens einer anorganischen Schicht (31, 131, 231) und mindestens einer organischen Schicht (32, 132, 232), wobei die mindestens eine anorganische Schicht (31, 131, 231) der zweiten Barrierestruktur (30, 130) die mindestens eine anorganische Schicht (24) der ersten Barrierestruktur kontaktiert, wobei die eingekapselte elektronische Anordnung freigesetzt (S11) wird aus dem Substrat (50) nach dessen Vollendung, **dadurch gekennzeichnet, dass** die eingekapselte Anordnung eine gemusterte zusätzliche organische Schicht (121) umfasst, die eine Freisetzungsschicht ist, die auf der ersten Barrierestruktur an einer Stelle, entfernt von der elektronischen Anordnung, angebracht wird, und das Muster, das eine Anordnung von Mikrolinsen in der Freisetzungsschicht (121) bildet, durch Verwendung eines Substrats mit einem komplementären Muster zu dem Substrat (50) erhalten wurde oder wobei mindestens eine weitere anorganische Schicht (222) der ersten Barrierestruktur der eingekapselten Anordnung versehen ist mit einem Muster, das eine Anordnung von Mikrolinsen bildet durch Bildung einer Freisetzungsschicht (251) mit einer gemusterten Oberfläche, die von dem Substrat weg zeigt, und durch Bildung der weiteren anorganischen Schicht (222) auf der Freisetzungsschicht (251), sodass sie der Freisetzungsschicht (251) folgt.

2. Verfahren nach Anspruch 1, **dadurch gekennzeichnet, dass** die erste Barrierestruktur (20) eine erste anorganische Schicht (22), eine erste organische Schicht (23), die die mindestens eine organische Schicht bildet, und eine zweite anorganische Schicht (24), die die mindestens eine anorganische Schicht bildet, umfasst, welche erste organische Schicht zwischen der ersten und der zweiten anorganischen Schicht angeordnet ist.

3. Verfahren nach Anspruch 1 oder 2, **dadurch gekennzeichnet, dass** die zweite Barrierestruktur (30) eine dritte anorganische Schicht (31), die die mindestens eine anorganische Schicht bildet, eine zweite organische Schicht (32), die die mindestens eine organische Schicht bildet, und eine vierte anorganische Schicht (33) umfasst, welche zweite organische Schicht zwischen der dritten und der vierten anorganischen Schicht angeordnet ist.

4. Verfahren nach einem der vorhergehenden Ansprüche, **dadurch gekennzeichnet, dass** die erste Barrierestruktur (20) und die zweite Barrierestruktur (30) eine gleiche Dicke haben.

5. Verfahren nach Anspruch 1, wobei die eingekapselte elektronische Anordnung eine OLED-Anordnung ist, mit der gemusterten zusätzlichen organischen Schicht (121), die eine Freisetzungsschicht ist, die auf der ersten Barrierestruktur an einer Stelle, entfernt von der elektronischen Anordnung angebracht wird, und **dadurch gekennzeichnet ist, dass** mindestens eine organische Schicht (351) Mikrolinsen oder Streupartikel (355) umfasst.

6. Verfahren nach einem der vorhergehenden Ansprüche, **dadurch gekennzeichnet, dass** mindestens eine organische Schicht einen Feuchtigkeitsfangstoff umfasst.

## Revendications

1. Procédé de fabrication d'un dispositif électronique encapsulé, comprenant les étapes suivantes :
fourniture (S1) d'un substrat (50) en un matériau inorganique,
fourniture d'un dispositif électronique encapsulé sur le substrat,
comprenant ensuite les sous-étapes suivantes :
fourniture (S4-S6) d'une première structure de barrière (20, 120) avec au moins une couche inorganique (24, 124, 224) et au moins une couche organique (23, 123, 223),
fourniture (S7) d'un dispositif électronique (10, 110, 210) entre la première et une deuxième structures de barrière (30, 130),
fourniture (S8-S10) de la deuxième structure de barrière (30, 130), avec au moins une couche inorganique (31, 131, 231) et au moins une couche organique (32, 132, 232),
dans lequel l'au moins une couche inorganique (31, 131, 231) de la deuxième structure de barrière (30, 130) vient au contact de l'au moins une couche inorganique (24) de la première structure de barrière, dans lequel le dispositif électronique encapsulé (S11) est libéré du substrat (50) après son achèvement, **caractérisé en ce que** le dispositif encapsulé comprend une couche organique additionnelle dotée d'un motif (121) qui est une couche de séparation qui est appliquée au niveau de ladite première structure de barrière sur un côté éloigné du dispositif électronique, et le motif formant un réseau de microlentilles dans ladite couche de séparation (121) a été obtenu par utilisation d'un substrat avec un motif complémentaire en tant que substrat (50), ou dans lequel au moins une autre couche inorganique (222) de la première structure de barrière du dispositif encapsulé est dotée d'un motif formant un réseau de microlentilles par formation d'une couche de séparation (251) avec une surface dotée d'un motif tournée à l'opposé du substrat et formant l'autre couche inorganique (222) sur la couche de séparation (251) de façon qu'elle suive la couche de séparation (251).

2. Procédé selon la revendication 1, **caractérisé en ce que** la première structure de barrière (20) comprend une première couche inorganique (22), une première couche organique (23) formant l'au moins une couche organique et une deuxième couche inorganique (24) formant l'au moins une couche inorganique, la première couche organique étant disposée entre les première et deuxième couches inorganiques.

3. Procédé selon la revendication 1 ou 2, **caractérisé en ce que** la deuxième structure de barrière (30) comprend une troisième couche inorganique (31) formant l'au moins une couche inorganique, une deuxième couche organique (32) formant l'au moins une couche organique et une quatrième couche inorganique (33), la deuxième couche organique étant disposée entre les troisième et quatrième couches inorganiques.

4. Procédé selon l'une des revendications précédentes, **caractérisé en ce que** la première structure de barrière (20) et la deuxième structure de barrière (30) ont une épaisseur égale.

5. Procédé selon la revendication 1, dans lequel ledit dispositif électronique encapsulé est un dispositif OLED ayant ladite couche organique additionnelle dotée d'un motif (121) qui est une couche de séparation qui est appliquée au niveau de ladite première structure de barrière sur un côté éloigné du dispositif électronique, et **caractérisé en ce qu'**au moins une couche organique (351) comprend des microlentilles ou des particules de diffusion (355).

6. Procédé selon l'une des revendications précédentes, **caractérisé en ce qu'**au moins une couche organique comprend un piège à humidité.
